# EUROPÄISCHE PATENTSCHRIFT

(11) **EP 0 411 596 B1**
(45) Veröffentlichungstag und Bekanntmachung des Hinweises auf die Patenterteilung: **11.05.1994**
(21) Anmeldenummer: 90114731.4
(22) Anmeldetag: 31.07.1990
(51) Int. Cl.: B23K 3/047, B23K 1/008

(54) **Ofen zum flussmittelfreien Löten oder Kleben von Halbleitermikrochips**
Oven for the soldering or sticking without flux of semiconducting microchips
Four pour le brasage ou le collage sans flux de micro-puces semi-conductrices

(30) Priorität: 31.07.1989 DE 3925340
(43) Veröffentlichungstag der Anmeldung: 06.02.1991
(73) Patentinhaber: SIEMENS AKTIENGESELLSCHAFT, 80333 München (DE)
(72) Erfinder: Bogner, Georg, Dipl.-Phys., D-8430 Neumarkt (DE); Hufgard, Erich, Dipl.-Phys., D-8400 Regensburg (DE); Althaus, Hans-Ludwig, Dr. Dipl.-Phys., D-8417 Lappersdorf (DE)

(56) Entgegenhaltungen:
- PATENT ABSTRACTS OF JAPAN vol. 10, no. 118 (M-475)(2175) 02 Mai 1986,& JP-A-60 247467 (TOSHIBA) 07 Dezember 1985,
- PATENT ABSTRACTS OF JAPAN vol. 13, no. 244 (M-834)(3592) 07 Juni 1989,& JP-A-01 53763 (KOMATSU) 01 März 1989,
- IEEE TRANSACTIONS ON COMPONENTS,HYBRIDS,AND MANUFACTURING vol. 11, no. 4, Dezember 1988, NEW YORK US Seiten 447-451 ; MIZUISHI et al.: "Fluxless and Virtually Voidless Soldering for Semiconductor Chips".

## Beschreibung

Die Erfindung betrifft einen Ofen zum flußmittelfreien Löten oder Kleben von Halbleiter-Mikrochips auf Trägersubstrate oder Kontaktteile, mit einer Ofenkammer, die eine Einrichtung zum Spülen mit Schutzgas und eine elektrisch gesteuerte Heizeinrichtung aufweist, wobei zumindest eines der zu verbindenden Teile während des Lötens oder Klebens durch eine Befestigungseinrichtung mit der Heizeinrichtung in direkten thermischen Kontakt gebracht ist.

Ein derartiger Ofen geht aus der Veröffentlichung in IEEE TRANSACTIONS ON COMPONENTS, HYBRIDS, AND MANUFACTURING vol. 11, no. 4, Dezember 1988, NEW YORK US, Seiten 447-451, von MIZUISHI et al.: "Fluxless and Virtually Voidless Soldering for Semiconductor Chips" als bekannt hervor.

Öfen zum flußmittelfreien Löten oder Kleben sind bekannt und werden beispielsweise in der Metall-, Keramik-, Glas- und Kunststoffindustrie für alle Arten der Wärmebehandlung verwendet. Je nach Art der Beheizung unterscheidet man zwischen elektrischen Öfen und solchen, die mit Gas oder Kohle beheizt werden. Bei den in Betracht zu ziehenden elektrischen Öfen wird wiederum zwischen Widerstandsöfen, Lichtbogenöfen und Induktionsöfen unterschieden, und zwar je nach der physikalischen Grundlage der Umwandlung der elektrischen in Wärmeenergie. Das Kammervolumen der Öfen liegt dabei zwischen wenigen Kubikzentimetern für Forschungs- und Laboratoriumszwecke bis hin zu einer Größenordnung von Kubikmetern bei technischen Öfen.

Zum flußmittelfreien Löten bzw. Kleben von Halbleiter-Mikrochips auf Wärmesenken bzw. Trägersubstrate wurden bisher derartige herkömmliche Ofensysteme verwendet. Die Wärmebehandlung erfolgt dabei durch mittelbare bzw. indirekte Erwärmung über Heizleiter in bzw. an der Ofenkammerwand. Die Ofenkammer muß während des Lötprozesses evakuiert und anschließend mit H₂-Gas gefüllt werden. Eine derartige Anlage ist in ihrer Funktionsweise relativ träge und aufwendig. Zum Löten bzw. Kleben von Mikrochips ebenfalls verwendbare Heizfolien sind zwar reaktionsschneller als die herkömmlichen Ofensysteme, allerdings neigen diese Folien beim Aufheizen zur Welligkeit. Die daraus resultierende Unebenheit der Auflagefläche ist bei der Winzigkeit der zu verbindenden Bauteile besonders störend.

Der Erfindung liegt die Aufgabe zugrunde, diese Nachteile zu vermeiden und einen Ofen zum flußmittelfreien Löten oder Kleben von Mikrochips zu schaffen, der bei geringer Heizleistung sehr reaktionsschnell und gut steuerbar ist.

Diese Aufgabe wird bei einem Ofen der eingangs genannten Art erfindungsgemäß dadurch gelöst, daß als Heizeinrichtung mindestens ein Halbleiterchip innerhalb der Ofenkammer angeordnet ist, der mindestens einen elektrisch lokal erhitzbaren Bereich aufweist.

Der vorzugsweise aus Silizium oder Siliziumkarbid bestehende Halbleiterchip weist dabei als lokal erhitzbaren Bereich einen ohmschen Widerstand, einen Schottky-Kontakt, d.h. einen Metall-Halbleiterkontakt, oder einen pn-Übergang auf.

Die Ofenkammer besteht beispielsweise aus einem Metall. Vorzugsweise ist die Ofenkammer aus einem Gehäuse gebildet, das mit einer Quarzabdeckung versehen ist, die zweckmäßig eine Öffnung aufweist. Die Öffnung ist verschließbar und dient zur Beschickung des Ofens. Die Quarzabdeckung dient als Sichthilfe.

Insbesondere dann, wenn das Gehäuse der Ofenkammer aus Metall besteht und der als Heizeinrichtung dienende Halbleiterchip an einer Wand der Ofenkammer befestigt ist, ist es zweckmäßig, den Halbleiterchip gegen die Gehäuse- bzw. Ofenwand thermisch zu isolieren. Als thermischer Isolator kann beispielsweise Quarzglas verwendet werden.

Die mit der Erfindung erzielten Vorteile bestehen insbesondere darin, daß das Halbleitersubstrat des bzw. der als Wärmequelle verwendeten Mikrochips gegenüber herkömmlichen Heizsystemen aus Metall im wesentlichen folgende Vorteile bietet:
a) höherer elektrischer Widerstand, dadurch Verringerung des Leitungsquerschnittes der elektrischen Zuleitungen,
b) geringere Masse, dadurch geringere Verlustleistung und höhere Dynamik,
c) durch unterschiedliche Dotierung in weitem Bereich einstellbarer elektrischer Widerstand des Halbleitermaterials, dadurch Verbesserung der Ansteuermöglichkeit.

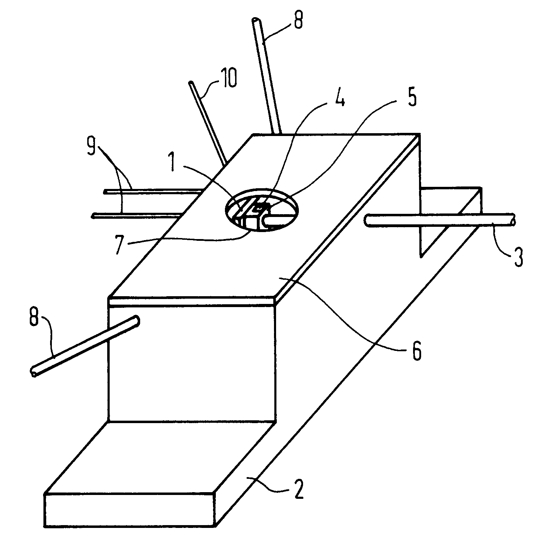

Anhand eines in der Figur der Zeichnung rein schematisch dargestellten Ausführungsbeispiels wird die Erfindung näher erläutert.

Bei dem in der Figur dargestellten Ofen werden zum Aufheizen der zu klebenden oder zu lötenden Teile ohmscher Widerstand bzw. Schottkykontakt oder pn-Übergang von Halbleiterchips 1 vorzugsweise aus Silizium oder Siliziumkarbid geeigneter Größe ausgenutzt, die als Wärmequelle dienen. Der Halbleiterchip 1 befindet sich elektrisch kontaktiert und thermisch isoliert in einer Ofenkammer 2 z.B aus Metall, beispielsweise Aluminium. Diese Ofenkammer 2 wird beim flußmittelfreien Löten mit Formiergas bzw. einem anderen Trägergas gespült und ist durch einen Deckel 6, z.B. aus Quarzglas, in dem sich eine Öffnung 7 befindet, abgedeckt. Durch diese Öffnung 7 können Träger- oder Kontaktteile 5 bzw. die zu lötenden Mikrochips 4 auf den als Wärmequelle vorgesehenen Halbleiterchip 1 zugeführt und festgehalten werden. In diesem Beispiel ist auf einem als Heizeinrichtung bzw. Wärmequelle dienenden Siliziumchip 1 ein zu lötender Mikrochip 4 auf einer Wärmesenke bzw. einem Trägersubstrat 5 angeordnet und das Trägersubstrat 5 mittels eines Bolzens 3 als Befestigungseinrichtung an der Siliziumwärmequelle 1 befestigt. Damit ist das Trägersubstrat 5 als mit dem Mikrochip 4 zu verbindendes Teil mit dem Halbleiterchip 1 in direkten thermischen Kontakt gebracht. Nach Einschalten des Stromes, der über die elektrischen Anschlüsse 9 dem Halbleiterchip 1 zugeführt wird, heizt sich der als Wärmequelle vorgesehene Halbleiterchip 1 je nach Regelprogramm auf und gibt die Wärme an die zu verlötenden oder zu verklebenden Bauteile ab.

Grundtemperatur, Aufheizgeschwindigkeit und Heizprofile können durch das (nicht dargestellte) Netzgerät vorgegeben werden. Die Temperaturüberwachung erfolgt zweckmäßig über ein im Inneren des Gehäuses 2 angeordnetes Thermoelement, dessen nach außen führende Verbindung in der Figur mit dem Bezugszeichen 10 versehen ist.

Eine homogene Schutzgasspülung, die über die Zu- bzw. Abführungen 8 erfolgt, verhindert beim Löten das Oxidieren der Lotoberfläche und macht Flußmittel überflüssig.

Insbesondere durch die geringe Masse der Wärmequelle, d.h. des Halbleiterchips, ist ein erfindungsgemäßer Mikroofen gegenüber herkömmlichen Öfen sehr reaktionsschnell und gut steuerbar. Die erforderliche Heizleistung ist auch bei sehr schnellem Hochheizen, beispielsweise in 0,5s auf 300°C, sehr gering.

## Patentansprüche

1. Ofen zum flußmittelfreien Löten oder Kleben von Halbleiter-Mikrochips (4) auf Trägersubstrate (5) oder Kontaktteile, mit einer Ofenkammer (2), die eine Einrichtung (8) zum Spülen mit Schutzgas und eine elektrisch gesteuerte Heizeinrichtung aufweist, wobei zumindest eines der zu verbindenden Teile (4, 5) während des Lötens oder Klebens durch eine Befestigungseinrichtung (3) mit der Heizeinrichtung in direkten thermischen Kontakt gebracht ist, **dadurch gekennzeichnet**, daß als Heizeinrichtung mindestens ein Halbleiterchip (1) innerhalb der Ofenkammer (2) angeordnet ist, der mindestens einen elektrisch lokal erhitzbaren Bereich aufweist.

2. Ofen nach Anspruch 1, **dadurch gekennzeichnet**, daß die Ofenkammer (2) aus einem Gehäuse besteht, das mit einer Quarzglasabdeckung (6) versehen ist, die eine Öffnung (7) aufweist.

3. Ofen nach Anspruch 1 oder 2, **dadurch gekennzeichnet**, daß die Befestigungseinrichtung (3) ein Befestigungsbolzen ist.

4. Ofen nach einem der Ansprüche 1 bis 3, **dadurch gekennzeichnet**, daß der Halbleiterchip (1) als lokal erhitzbaren Bereich einen ohmschen Widerstand, einen Schottky-Kontakt oder einen pn-Übergang aufweist.

5. Ofen nach einem der Ansprüche 1 bis 4, **dadurch gekennzeichnet**, daß der Halbleiterchip (1) aus Silizium oder aus Siliziumkarbid besteht.

6. Ofen nach einem der Ansprüche 1 bis 5, **dadurch gekennzeichnet**, daß der als Heizeinrichtung dienende Halbleiterchip (1) an einer Wand der Ofenkammer (2) gegen diese thermisch isoliert befestigt ist.

## Claims

1. Furnace for the flux-free soldering or bonding of semiconductor microchips (4) to carrier substrates (5) or contact parts, having a furnace chamber (2) which comprises a device (8) for flushing with protective gas and an electrically controlled heating device, at least one of the parts (4, 5) to be joined being brought into direct thermal contact with the heating device by means of a fixing device (3) during the soldering or bonding, characterized in that at least one semiconductor chip (1) is disposed inside the furnace chamber (2) as heating device and has at least one region which can be electrically heated locally.

2. Furnace according to Claim 1, characterized in that the furnace chamber (2) comprises a housing which is provided with a quartz glass cover (6) having an opening (7).

3. Furnace according to Claim 1 or 2, characterized in that the fixing device (3) is a fixing bolt.

4. Furnace according to one of Claims 1 to 3, characterized in that the semiconductor chip (1) has an ohmic resistor, a Schottky contact or a p-n junction as region which can be heated locally.

5. Furnace according to one of Claims 1 to 4, characterized in that the semiconductor chip (1) comprises silicon or silicon carbide.

6. Furnace according to one of Claims 1 to 5, characterized in that the semiconductor chip (1) which serves as heating device is attached to a wall of the furnace chamber (2) and thermally insulated from it.

## Revendications

1. Four pour le brasage sans flux ou pour le collage de micro-puces (4) semiconductrices sur des substrats (5) servant de support ou sur des pièces de contact, comprenant une chambre de four (2), qui comporte un dispositif (8) de balayage par du gaz protecteur et un dispositif de chauffage à commande électrique, au moins l'une des pièces (4, 5) à relier étant mise, pendant le soudage ou le collage, en contact thermique direct avec le dispositif de chauffage par un dispositif (3) de fixation, caractérisé en ce qu'il est prévu, à l'intérieur de la chambre du four, comme dispositif de chauffage, au moins une puce (1) semiconductrice, qui comporte au moins une partie pouvant être chauffée localement par voie électrique.

2. Four suivant la revendication 1, caractérisé en ce que la chambre (2) du four est constituée d'une enveloppe munie d'un couvercle (6) en verre au quartz et ayant une ouverture (7).

3. Four suivant la revendication 1 ou 2, caractérisé en ce que le dispositif (3) de fixation est un axe de fixation.

4. Four suivant l'une des revendications 1 à 3, caractérisé en ce que la puce (1) semiconductrice comporte, comme partie pouvant être chauffée localement, une résistance ohmique comprenant un contact Schottky ou une jonction pn.

5. Four suivant l'une des revendications 1 à 4, caractérisé en ce que la puce (1) semiconductrice est en silicium ou en carbure de silicium.

6. Four suivant l'une des revendications 1 à 5, caractérisé en ce que la puce (1) semiconductrice servant de dispositif de chauffage est fixée à une paroi de la chambre (2) du four en étant isolée thermiquement de celle-ci.
